# EUROPEAN PATENT APPLICATION

(11) **EP 2 759 761 A1**
(43) Date of publication of application: **30.07.2014**
(21) Application number: 12833984.3
(22) Date of filing: 19.09.2012
(51) Int. Cl.: F21S 4/00, F21V 19/00, F21V 3/00, F21Y 101/02

(54) **IMPROVED LED LAMP TUBE STRUCTURE**

(30) Priority: 23.09.2011 CN 201110285914
(71) Applicant: Jiangsu Sun & Moon Lighting Co., Ltd, Yancheng, Jiangsu 224700 (CN); Great Electronic Xiamen Co., Ltd, Xiamen, Fujian 361009 (CN)
(72) Inventor: OUYANG, Wei, Xiamen Fujian 361009 (CN); OUYANG, Chie, Xiamen Fujian 361009 (CN)
(74) Representative: Wang, Xiaodi
(86) International application number: PCT/CN2012/081585
(87) International publication number: WO 2013/041018

(57) **Abstract**

An improved LED lamp tube structure includes a shell (6) and a PC cover (7). The shell (6) and a PC cover (7) can be fastened to each other to form a cavity (61). A circuit board (1) is disposed in the cavity (61). A plurality of LEDs (5) is mounted on the circuit board (1) and arranged in the longitudinal direction of the circuit board (1). Each of LEDs (5) has a light-emission angle. The PC cover (7) has an arc angle equal to the light-emission angle. Each of the LEDs (5) extends in a direction perpendicular to the longitudinal direction of the circuit board (1).

## Description

### FIELD OF THE INVENTION

The present invention relates to a light emitting diode (LED) lamp which has an improved structure to attenuate black areas at both sides of the LED lamp.

### BACKGROUND

As technology of LED continues developing, many manufacturers consider the use of domestic and cheap labors to produce LED lamps for sales to Europe and other overseas sales. However, it is necessary to achieve European product certification for sales to Europe.

For example, the European product certification requests that the distance between a LED and the outer edge of an aluminum plate is at least 5 mm in a LED lamp tube. The conventional technology of LED uses an oblique of horizontal arrangement to make sure that the LED lamp tube emits light in the longitudinal direction of PC cover and to decrease the number of LEDs. According to the oblique or horizontal arrangement, the LED lamp tube is bright in the longitudinal direction but dark at two transverse sides of the PC cove. It reduces the quality of the product and thus causes that the LED lamp tube looks poor aesthetic when the LEM lamp tube is lighted. For that reason, the atmosphere caused by the lighted LED lamp tube is affected. In the conventional LED lamp tube, the arrangement of LEDs does not extend to two ends because of central luminance and a decrease in the number of LEDs so that two dark areas are formed at two ends of the LED lamp tube. Therefore, the aforementioned two dark areas and the darkness at two transverse sides of the PC cove reduce the quality of the product and cause that the LED lamp tube looks poor aesthetic, thereby affecting the atmosphere of the lighted LED lamp tube.

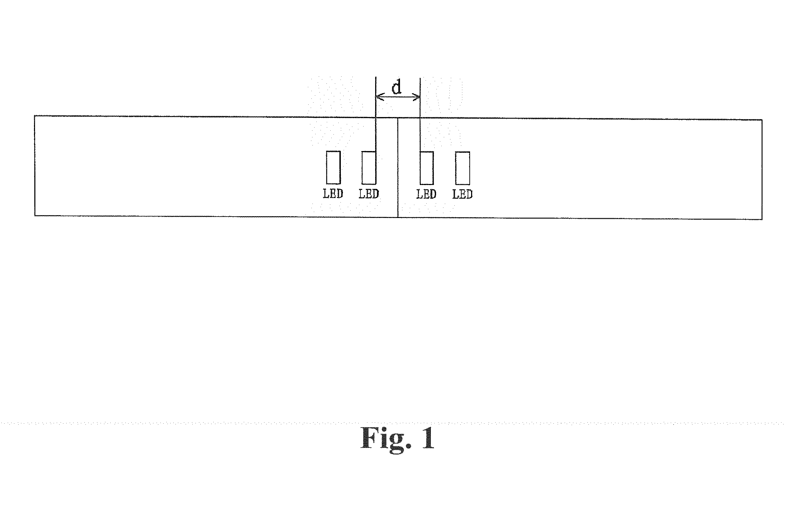

As shown in FIG. 1, even if the LED lamp tubes are designed under the minimum requirement of European product certification, the maximum length of a single light board within the LED lamp tube is about 60 cm because of the limitation of conventional attaching equipment. If a light board of the LED lamp has the length other than 60 cm, the light board will be made by merging two aluminum plates. Accordingly, a gap d formed between two adjacent LEDs has a length of at least 10mm so that a dark area may be formed in the central section of the entire LED lamp tube. It causes to reduce the quality of the product greatly, thereby weakening superiority of product in European market. Moreover, because the arrangement of LEDs does not extend to two ends of the LED lamp tube, the two ends become dark when lighting the LED lamp tube.

Therefore, in order to solve the drawbacks of the conventional LED lamp, the present invention is provided.

### SOME EXEMPLARY EMBODIMENTS

The purpose of the present invention is to provide an improved LED lamp tube structure to solve the drawbacks of the aforementioned dark areas.

In order to achieve the purpose, the present invention discloses an LED lamp tube structure including a shell and a PC cover fastened, in which the shell and the PC cover can be fastened to each other to form a cavity. A circuit board is disposed in the cavity. A plurality of LEDs is mounted on the circuit board and arranged in the longitudinal direction of the circuit board. In addition, each of LEDs has a light-emission angle. The PC cover has an arc angle, and the arc angle is equal to the light-emission angle. Each of the LEDs extends in a direction perpendicular to the longitudinal direction of the circuit board.

By the aforementioned structure, the present invention involves an improved LED lamp tube structure. Each of the LEDs extends in a direction perpendicular to the longitudinal direction of the circuit board so as to enlarge the bright area in the transverse direction of the PC cover, wherein the bright area is formed by the light from each LED illuminating the PC cover. Accordingly, it can eliminate the darkness areas in the transverse direction of the PC cover. In addition, the PC cover has an arc angle equal to the light-emission angle. Specifically, the increase of the distance between the LED and the PC cover can make the light completely emitted to the PC cover, thereby achieving a good illumination atmosphere and eliminating the dark areas at both sides.

### BRIEP DESCRIPTION OF THE DRAWINGS

The invention is illustrated by way of example, and not by way of limitation, in the figures of the accompanying drawings in which like reference numerals refer to similar elements and in which:
FIG. 1 illustrates the dark area caused by merging two aluminum plates in prior art;
FIG. 2 illustrates an conventional LED lamp tube structure;
FIG. 3 illustrates an LED lamp tube structure according to the present invention;
FIG. 4 illustrates LEDs arranged on the circuit board according to the present invention;
FIG. 5 illustrates the structure formed by merging the first and the second substrates in the LED lamp tube according to the present invention;
FIG. 5A is the side view of FIG. 5;
FIG. 6 illustrates the tube and the inner board both in the conventional LED lamp tube;
FIG. 7 illustrates the tube and the inner board both in the LED lamp tube according to the present invention; and
FIG. 8 is the enlarged view of the PC cover according to the present invention.

### DESCRIPTION OF THE PREFERRED EMBODIMENT

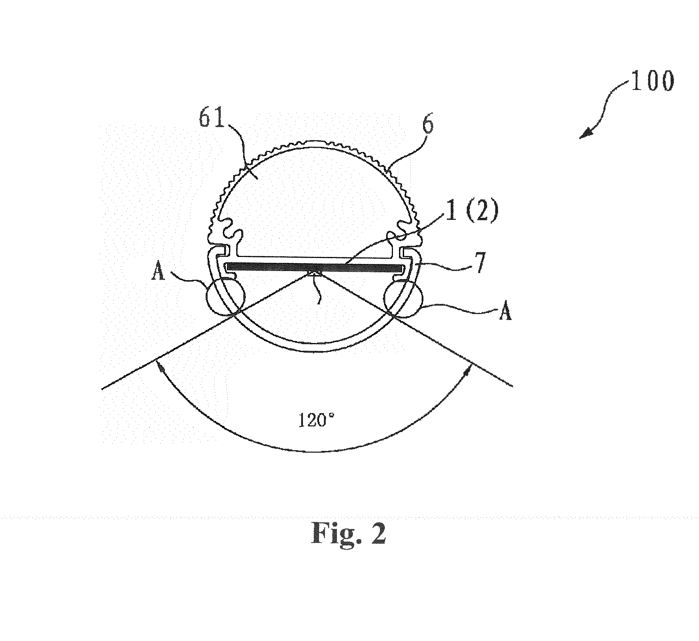

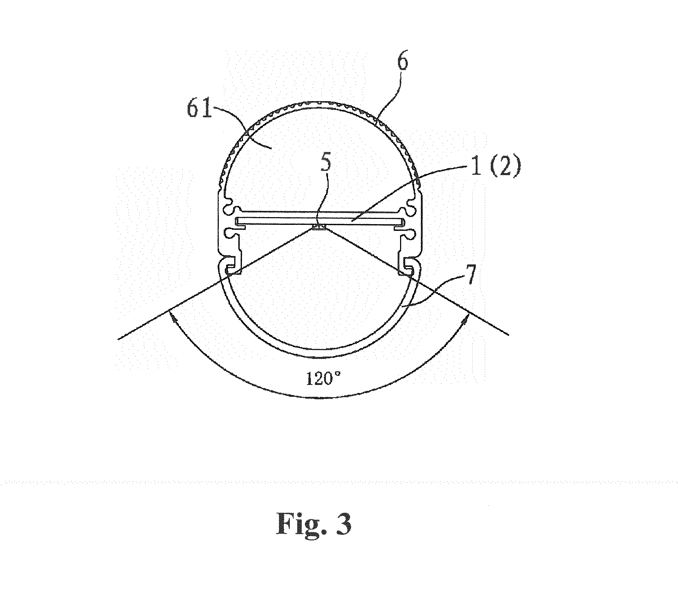

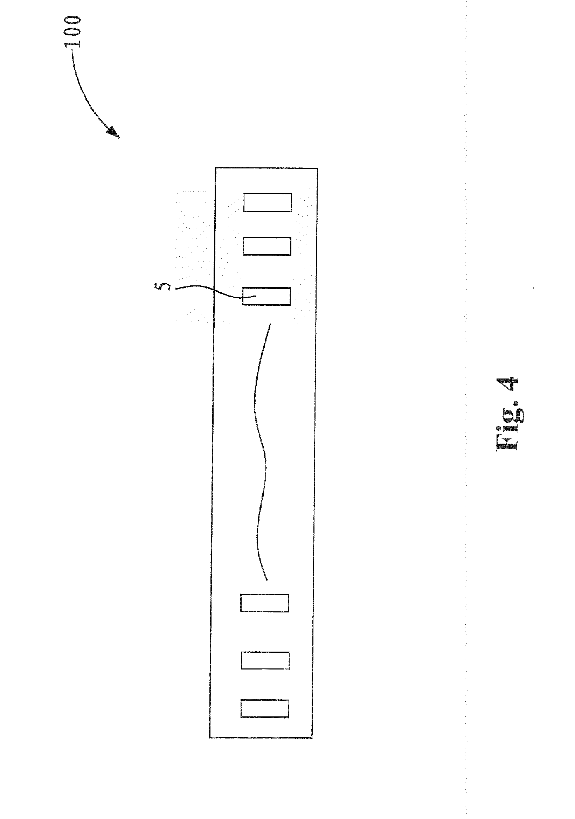

Refer to FIG. 2 and FIG. 3, that is, compare the prior art to the present invention. The conventional LED lamp tube 100 further includes a shell 6 and a PC cover 7. The shell 6 and the PC cover 7 can be fastened to each other. After the hell 6 and the PC cover 7 are fastened to each other, a cavity 61 is formed. The circuit board is disposed in the cavity 61. In specific embodiment, the circuit board includes a first substrate 1 and a second substrate 2. In other words, the first substrate 1 and the second substrate 2 both are disposed in the cavity 61. The conventional LED lamp tube 100 has a light-emission angle of 120°. The PC cover 7 covers more than half of the shell 6, and thus dark areas A are each formed at both sides of the PC cover 7 respectively. Referring to FIG. 3, in order to control and eliminate the dark areas A, the PC cover 7 has an arc angle equal to the light-emission angle. In the present embodiment, the arc angle of the PC cover 7 is 120° so as to prevent the aforementioned dark areas A. Specifically, the dark areas A are eliminated and controlled by an increase of the distance between the LED and the PC cover 7, thereby achieving a good illumination atmosphere. Referring to FIG. 4, each of the LEDs extends in a direction perpendicular to the longitudinal direction of the circuit board so as to enlarge the bright area in the transverse direction of the PC cover, wherein the bright area is formed by the light from each LED illuminating the PC cover. Accordingly, it can improve an illumination effect in the transverse direction of the PC cover, thereby facilitating the elimination of darkness areas.

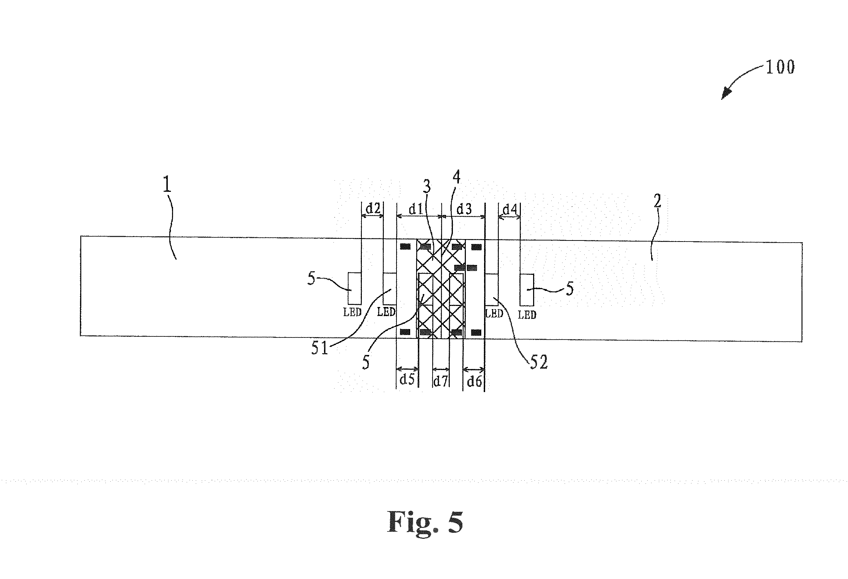

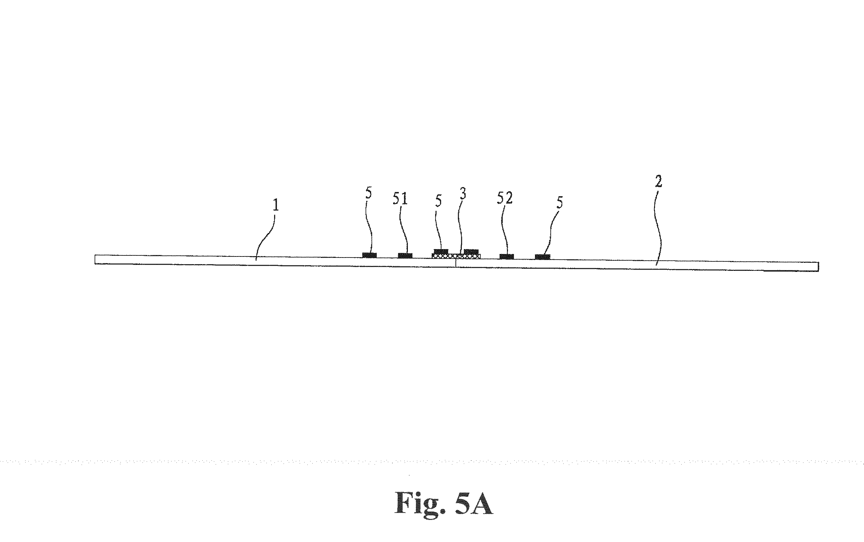

In addition, referring to FIGS. 5 and 5A, the present invention involves an LED lamp tube 100. The circuit board includes a first substrate 1, a second substrate 2, and a connecting board 3. The first substrate 1 and the second substrate 2 can be assembled to form a lamp tube with the length according actual needs. Moreover, the first substrate 1 and the second substrate 2 form a boundary 4. Multiple LEDs 5 are mounted on both the first substrate 1 and the second substrate 2. The LED 5 mounted on the first substrate 1 adjacent to the boundary 4 is named a first end LED 51, whereas the LED 5 mounted on the second substrate 2 adjacent to the boundary 4 is named a second end LED 52. The connecting board 3 attaches the first substrate 1 and the second substrate 2, for example by soldering. The connecting board 3 covers the boundary 4 and is placed between the first end LED 51 and the second end LED 52. Furthermore, at least one LED 5 is mounted on the connecting board 3.

Therefore, after the first substrate 1 and the second substrate 2 are assembled, the connecting board 3 is disposed on a blank section formed between the first end LED 51 and the second end LED 52. The LED 5 mounted on the connecting board 3 can emit light to eliminate the aforementioned dark areas.

Preferably, referring to FUG. 5, in order to eliminate the dark areas completely, a distance D1 between the first end LED 51 and the boundary 4 is longer than a distance D2 between two adjacent LEDs 5 mounted on the first substrate 1. A distance D3 between the second end LED 52 and the boundary 4 is longer than a distance D4 between two adjacent LEDs 5 mounted on the second substrate 2. A distance D5 between the connecting board 3 and the first end LED 5 is equal to the distance D2. A distance D6 between the connecting board 3 and the second end LED 52 is equal to the distance D4. In the present embodiment, the structures of both the first substrate 1 and the second substrate 2 are basically the same, and the distance D2 is equal to the distance D4. Moreover, the distance D7 is equal to the distance D2 or the distance D4 so that the illumination effect after the first substrate 1 and the second substrate 2 are assembled is the same as the illumination effect of a single light board, thereby eliminating both the dark areas completely and the formation of central bright area. Preferably, the connecting board 3 may be a glass-fiber board or a bakelite board. In order to enhance the thermal dissipation ability of the entire LED lamp tube 100, the first substrate 1 and the second substrate 2 can be aluminum plates.

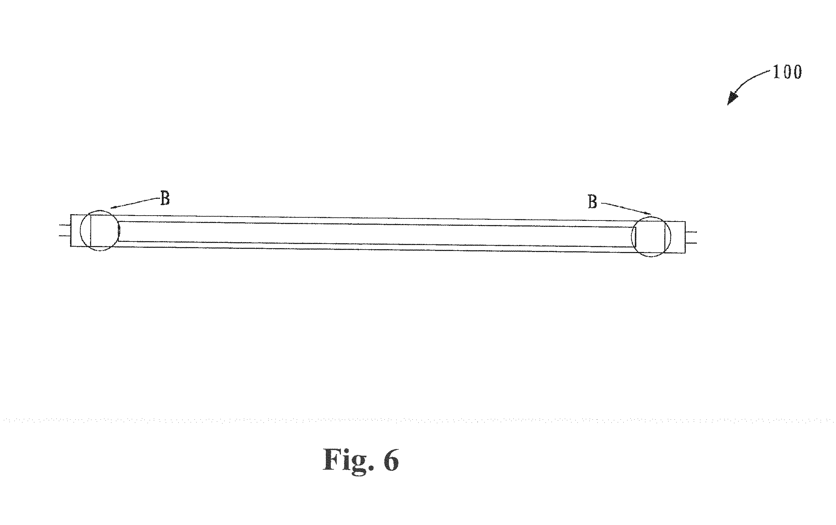

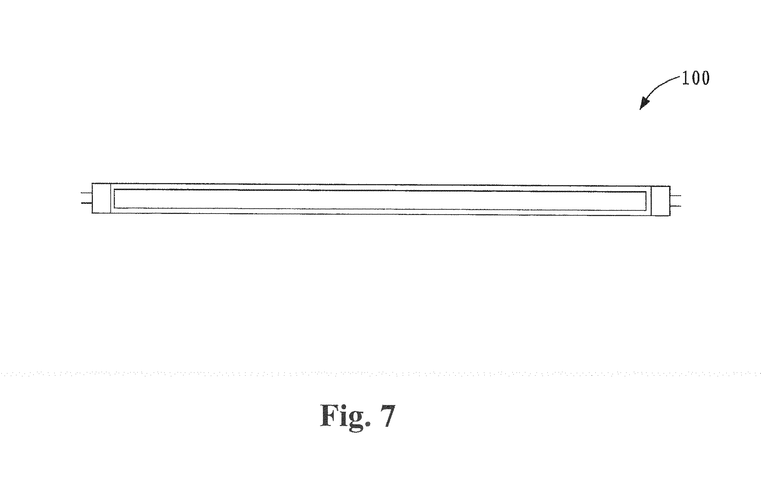

Refer to FIG. 6 and FIG. 7, that is, compare the prior art to the present invention. The tube does not extent to the two ends of the conventional LED lamp tube 100 so that dark areas B are formed at the two ends respectively. In order to eliminate the dark areas B, a side of the first substrate 1 that is far away from the second substrate 2 is close to the end of the LED lamp tube 100. Specifically, the distribution of LEDs is loose so that the extension of the arrangement of the LEDs can stretch to the two ends. A side of the second substrate 2 that is far away from the first substrate 1 is close to the end of the LED lamp tube 100. In addition, a distance between the PC cover 7 and the LED 5 is increased so the LEDs 5 illuminate the PC cover uniformly. Therefore, the ends of the LED lamp tube 100 become bright, thereby eliminating the dark areas B.

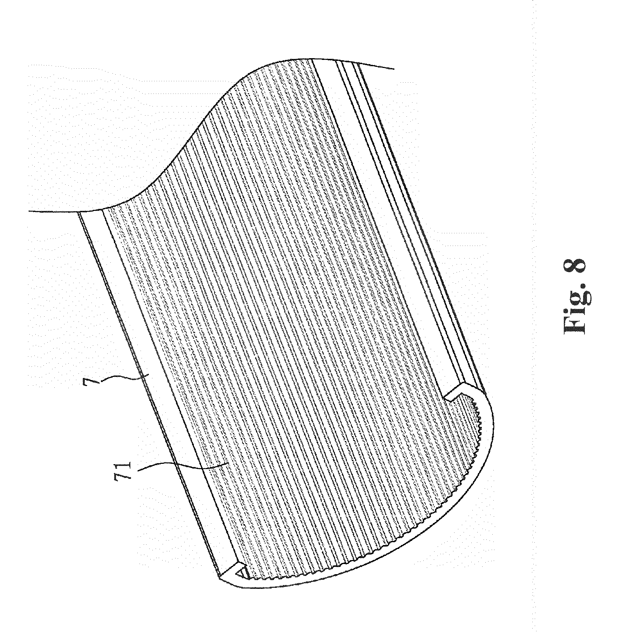

Referring to FIG. 8, in order to make the LED lamp tube provide more even lighting, a plurality of strips 71 is formed on the PC cover 7 and extends in the longitudinal direction of the PC cover 7. Preferably, the strips are parallel to each other.

While the disclosure has been described in connection with a number of embodiments and implementations, the disclosure is not so limited but covers various obvious modifications and equivalent arrangements, which fall within the purview of the appended claims. Although features of the disclosure are expressed in certain combinations among the claims, it is contemplated that these features can be arranged in any combination and order.

## Claims

1. A improved LED lamp tube structure comprising:
a shell; and
a PC cover having an arc angle and fastened to the shell to form a cavity where a circuit board is disposed, and a plurality of LEDs is mounted on the circuit board and arranged in a longitudinal direction of the circuit board; wherein each of the LEDs has a light-emission angle equal to the arc angle, and each of the LEDs extends in a direction perpendicular to the longitudinal direction of the circuit board.

2. The structure according to claim 1, wherein a plurality of strips is formed on the PC cover and extends in a longitudinal direction of the PC cover.

3. The structure according to claim 1 further comprising a connecting board, the circuit board comprising a first substrate and a second substrate assembled to the first substrate, the first substrate and the second substrate forming a boundary, a plurality of LEDs mounted on both the first substrate and the second substrate, wherein the LED mounted on the first substrate adjacent to the boundary is a first end LED, whereas the LED mounted on the second substrate adjacent to the boundary is a second end LED, wherein the connecting board covers the boundary and is placed between the first end LED and the second end LED, and at least one LED is mounted on the connecting board.

4. The structure according to claim 3, wherein a distance between the first end LED and the boundary is longer than a distance between two adjacent LEDs mounted on the first substrate, whereas a distance between the second end LED and the boundary is longer than a distance between two adjacent LEDs mounted on the second substrate; wherein a distance between the connecting board and the first end LED is equal to the distance between two adjacent LEDs mounted on the first substrate, whereas a distance between the connecting board and the second end LED is equal to the distance between two adjacent LEDs mounted on the second substrate.

5. The structure according to claim 4, wherein the distance between two adjacent LEDs mounted on the first substrate is equal to the distance between two adjacent LEDs mounted on the second substrate.

6. The structure according to claim 5, wherein a distance between two adjacent LEDs mounted on the connecting board is equal to the distance between two adjacent LEDs mounted on the first substrate or on the second substrate.

7. The structure according to one of claims 3 to 6, wherein the connecting board is a glass-fiber board or a bakelite board.

8. The structure according to one of claims 3 to 6, wherein the first substrate and the second substrate are both aluminum plates.

9. The structure according to claim 3, wherein a side of the first substrate that is far away from the second substrate is close to one end of the LED lamp tube, whereas a side of the second substrate that is far away from the first substrate is close to the other end of the LED lamp tube.
